Europäisches Patentamt

European Patent Office

Office européen des brevets

(19)

(11) Veröffentlichungsnummer: **0 048 830**
A2

(12) # EUROPÄISCHE PATENTANMELDUNG

(21) Anmeldenummer: **81106751.1**

(51) Int. Cl.³: **H 01 L 31/02, H 01 L 23/48**

(22) Anmeldetag: **29.08.81**

(30) Priorität: **26.09.80 DE 3036261**
**23.06.81 DE 3124581**

(43) Veröffentlichungstag der Anmeldung: **07.04.82**
**Patentblatt 82/14**

(84) Benannte Vertragsstaaten: **FR GB IT NL**

(71) Anmelder: **Licentia Patent-Verwaltungs-GmbH,**
**Theodor-Stern-Kai 1, D-6000 Frankfurt/Main 70 (DE)**

(72) Erfinder: **Dahlberg, Reinhard, Dr., Innere Bergstrasse 32,**
**D-7101 Flein (DE)**

(74) Vertreter: **Langer, Karl-Heinz, Dipl.-Ing. et al, Licentia**
**Patent-Verwaltungs-GmbH Theodor-Stern-Kai 1,**
**D-6000 Frankfurt/Main 70 (DE)**

(54) **Solarzellen-Anordnung.**

(57) Die Erfindung betrifft eine Solarzellen-Anordnung aus elektrisch zusammengeschalteten Solarzellen, bei der die elektrischen Kontakte zwischen den Solarzellen mit Hilfe von Bändern oder Drähten aus amorphen Metallen hergestellt sind.

EP 0 048 830 A2

0048830

Licentia Patent-Verwaltungs-G.m.b.H.
Theodor-Stern-Kai 1, 6000 Frankfurt 70

Heilbronn, 10.06.81
SE2-HN-La/bg - HN 81/26

## Solarzellen-Anordnung

Ein wichtiger Gesichtspunkt bei der Zusammenschaltung von Solarzellen zu größeren Anordnungen, sogenannten "Panels", besteht in der Langlebensdauer dieser Panels. Kritischer Punkt in Bezug auf die Langlebensdauer sind die elektrischen Verbindungen zwischen den einzelnen Solarzellen. Die Solarzellen erwärmen sich im Betrieb über die Umgebungstemperatur und kühlen bei Nacht oder bei reduzierter Bestrahlung wieder ab. Dadurch entstehen thermische Ausdehnungsunterschiede, die als mechanische Beanspruchung auf die Kontaktverbindungen wirken. Im Langzeitbetrieb kann dadurch eine Ermüdung der Kontakte eintreten, welche Unterbrechungen zur Folge haben können.

Der Erfindung liegt die Aufgabe zugrunde, eine Solarzellen-Anordnung anzugeben, die diese Nachteile nicht aufweist und die einen zuverlässigen Langlebensdauerkontakt zwischen den Solarzellen besitzt. Diese Aufgabe wird bei einer Solarzellen-Anordnung aus elektrisch zusammengeschalteten Solarzellen nach der Erfindung dadurch gelöst, daß für die elektrischen Kontakte zwischen den Solarzellen Bänder oder Drähte aus amorphem Metall verwendet werden. Amorphe Metalle zeigen auf Grund der Tatsache, daß sie kein Kristallgitter haben, keinerlei mechanische Ermüdungserscheinungen. Sie besitzen darüber hinaus ein sehr gutes Korrosionsverhalten. Beide Eigenschaften macht sie besonders geeignet für lanzeitstabile elektrische Verbindung zwischen Solarzellen.

Besonders kostengünstig sind amorphe Metalle, welche als Legierungskomponenten Eisen, Aluminium, Zink, Blei, Zinn, Kupfer, Nickel, Kobalt, Chrom, Molybdän oder Vanadium enthalten. Diesen Legierungskomponenten werden vorteilhafterweise nichtmetallische Stoffe, wie Bor, Silizium, Kohlenstoff, Phosphor, Arsen oder andere zugemischt. Das Anbringen der amorphen Metallbänder oder -drähte an den Vorderseiten bzw. am Rückseitenkontakt der Solarzelle geschieht vorzugsweise mit Hilfe von Ultraschallbondung. Der Vorderseiten- und Rückseitenkontakt an der Solarzelle kann jedoch auch durch Anlöten oder Anschweißen eines Metallteiles starr ausgebildet sein, und die amorphen Metallbänder oder -Drähte können an diesen Metallteilen mit Hilfe eines mechanischen Druck-Kontaktes, eines Klebe-Kontaktes, eines Löt-Kontaktes oder eines Schweiß-Kontaktes elektrisch gut leitend angebracht sein.

Die Erfindung wird im folgenden an Ausführungsbeispielen näher erläutert.

Ausführungsbeispiel 1

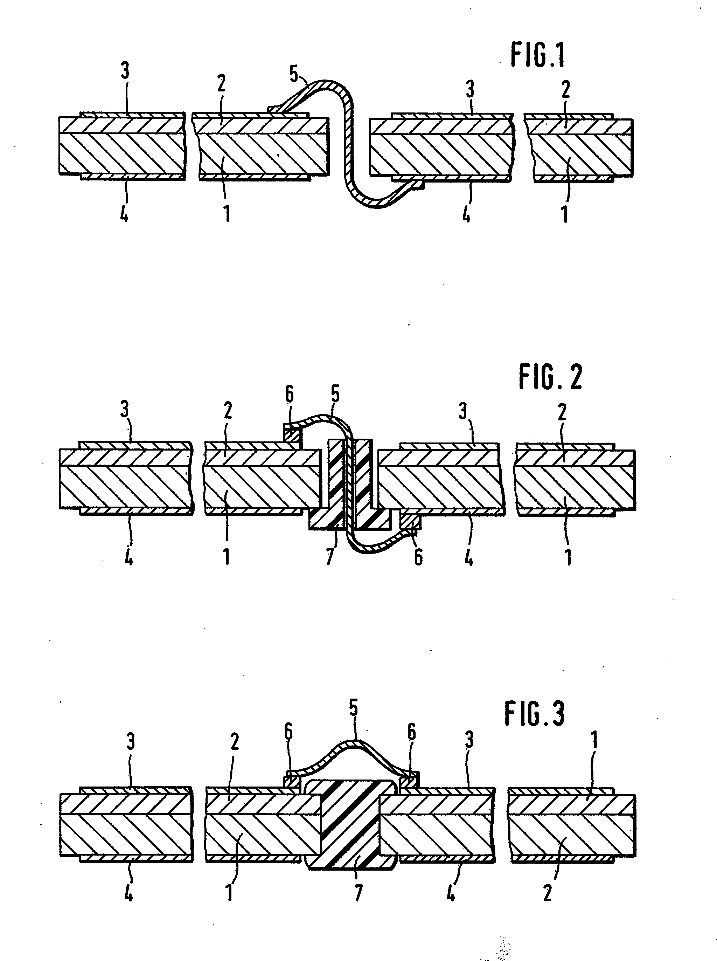

In Fig. 1 sind zwei Solarzellen aus p-Silizium 1 und einer $n^+$-Siliziumzone 2 mit den Kontakten 3 für die Vorderseite und den Kontakten 4 für die Rückseite versehen. Der Vorderseiten-Kontakt 3 der linken Solarzelle ist über die Folie 5 aus der amorphen Metall-Legierung $Fe_{80}B_{20}$ (Eine Legierung aus 80 Gewichts % Eisen und 20 Gewichts % Bor) mit dem Rückseiten-Kontakt 4 der rechten Solarzelle elektrisch leitend verbunden. Dadurch sind beide Solarzellen elektrisch in Serie geschaltet.

0048830

Anwendungsbeispiel 2

In Fig. 2 ist an den Vorderseiten-Kontakt 3 der $n^+$-Zone 2 der linken Solarzelle und an den Rückseiten-Kontakt 4 der p-Zone 1 der rechten Solarzelle je ein Metallteil 6 starr angelötet. Durch die Isolatorstütze 7, zwischen den beiden benachbarten Solarzellen, führt ein Draht 5 aus amorphem Metall, beispielsweise mit der Zusammensetzung $Fe_{60}Cr_6Mo_6B_{28}$, (Gewichts %), der die Metallteile 6 auf der Oberseite der linken und der Rückseite der rechten Solarzelle elektrisch leitend miteinander verbindet und die Solarzellen damit elektrisch in Serie schaltet.

Anwendungsbeispiel 3

In Fig. 3 ist links eine $p/n^+$-Solarzelle 1/2 und rechts eine $n/p^+$-Solarzelle 2/1 dargestellt. Über die elastische Isolatorstütze zwischen den beiden Solarzellen sind diese mechanisch miteinander verbunden. Ein Band aus amorphem Metall 5, beispielsweise mit der Zusammensetzung $Fe_{80}P_{13}C_7$, (Gewichts %) verbindet die Metallteile 6 auf den Vorderseiten-Kontakten 3 der beiden Solarzellen, die dadurch elektrisch in Serie geschaltet sind. 4 sind die jeweiligen Rückseiten-Kontakte der Solarzellen.

0048830

### Bezugsziffern

1 p-leitendes Silizium

2 n-leitendes Silizium

3 Vorderseiten-Kontakt

4 Rückseitenkontakt

5 Band aus amorphem Metall

6 Metallteil

7 Isolatorstütze

0048830

Licentia Patent-Verwaltungs-G.m.b.H.
Theodor-Stern-Kai 1, 6000 Frankfurt 70

Heilbronn, 10.06.81
SE2-HN-La/bg - HN 81/26

## Patentansprüche

1) Solarzellen-Anordnung aus elektrisch zusammengeschalteten Solarzellen dadurch gekennzeichnet, daß die elektrischen Kontakte zwischen den Solarzellen mit Hilfe von Bändern oder Drähten aus amorphen Metallen hergestellt sind.

2) Solarzellen-Anordnung nach Anspruch 1, dadurch gekennzeichnet, daß als Solarzellen Silizium-Solarzellen verwedendet sind.

3) Solarzellen-Anordnung nach Anspruch 1 oder 2, dadurch gekennzeichnet, daß die elektrischen Kontakte aus amorphen Metallen aus Legierungen bestehen, die Legierungskomponenten wie Eisen, Kupfer, Nickel, Kobalt, Chrom, Molybdän, Aluminium, Zink, Blei, Zinn oder Vanadium enthalten, oder daß die elektrischen Kontakte aus Mischungen der genannten Legierungskomponenten mit nicht metallischen Stoffen, wie Bor, Kohlenstoff, Phosphor, Arsen oder Silizium bestehen.

0048830

FIG.1

FIG.2

FIG.3